# EUROPEAN PATENT APPLICATION

(11) **EP 3 192 771 A1**
(43) Date of publication of application: **19.07.2017**
(21) Application number: 17150972.2
(22) Date of filing: 11.01.2017
(51) Int. Cl.: B81B 7/00

(54) **ELECTRONIC DEVICE, ELECTRONIC APPARATUS, AND MOVING OBJECT**

(30) Priority: 13.01.2016 JP 2016004775
(71) Applicant: Seiko Epson Corporation, Tokyo 160-8801 (JP)
(72) Inventor: Naruse, Atsuki, Nagano, 392-8502 (JP)
(74) Representative: Hoffmann Eitle

(57) **Abstract**

An electronic device includes a package (30) housing a physical quantity sensor (3) and comprising a base (31) and a lid (32). The electronic device includes also an IC (4) that is electrically connected to the sensor, a fixing member (21) and a support member (5) that supports the IC and the package containing the physical quantity sensor. The support member is disposed such that the package containing the physical quantity sensor is spaced apart from the fixing member.

## Description

### BACKGROUND

### 1. Technical Field

The present invention relates to an electronic device, an electronic apparatus, and a moving object.

### 2. Related Art

In the related art, an electronic device in which a sensor element such as an acceleration sensor element and an angular velocity sensor element is packaged is described (for example, see JP-A-2005-538551). The electronic device of JP-A-2005-538551 has a cavity-shaped package, an isolator that is fixed to a bottom surface of the package via adhesive, and a gyroscope die (electronic component) that is fixed to an upper surface of the isolator via adhesive, and is configured to reduce thermal stress that is generated due to a difference in linear expansion coefficient between the package and the gyroscope die using the isolator. Therefore, it is possible to obtain an effect that the stress is unlikely to be transmitted to the gyroscope die.

However, in the configuration of JP-A-2005-538551, since the bottom surface of the gyroscope die is fixed to the package via the isolator, as before, it is considered that the thermal stress is easily transmitted to the gyroscope.

### SUMMARY

An advantage of some aspects of the invention is to provide an electronic device in which stress is unlikely to be added to an electronic component, an electronic apparatus, and a moving object.

The invention can be realized in the following aspects or application examples.

According to an aspect of the invention, there is provided an electronic device including a package including a base and a lid body joined to the base, and an electronic component having a functional element housed in the package; a circuit device that is electrically connected to the electronic component; a support member that supports the electronic component and the circuit device; and a fixing member that fixes the support member. The electronic component is disposed to be spaced apart from the fixing member. The electronic component is suspended from the fixing member in a direction in which the electronic component is spaced apart from the fixing member.

As described above, the electronic component is fixed to the fixing member via the support member, the electronic component is in a suspended state with respect to the fixing member, and thereby a stress is unlikely to be transmitted to the electronic component.

In the electronic device, it is preferable that the electronic component and the circuit device be disposed to face each other via the support member.

Therefore, disposition of the electronic component and the circuit device are easily performed.

In the electronic device, it is preferable that the functional element be fixed to the base, and the electronic component be fixed to the support member in the lid body.

Therefore, since it is possible to lengthen a propagation path of the stress that can be transmitted from the support member to the functional element, the stress is further unlikely to be transmitted to the functional element.

In the electronic device, it is preferable that the circuit device have a circuit device substrate and a circuit element that is disposed in the circuit device substrate, and the lid body and the circuit device include the same material as each other.

Therefore, since the support member is sandwiched by the same material from both sides, it is possible to reduce deflection of the support member due to heat. Thus, it is possible to reduce occurrence of a thermal stress and accordingly also to reduce a stress that can be transmitted to the electronic component.

In the electronic device, it is preferable that the fixing member have a bottom portion and a side wall portion standing upright from the bottom portion, and the support member be fixed to the side wall portion.

Therefore, a configuration of the electronic device is simplified.

In the electronic device, it is preferable that the support member have a base portion that is disposed to face the fixing member with a gap therebetween and a connecting portion that is disposed between the base portion and the fixing member, and connect the base portion and the fixing member.

Therefore, a configuration of the electronic device is simplified.

In the electronic device, it is preferable that an outside lid portion that is joined to the fixing member be further provided so as to form a housing space for housing the electronic component, the circuit device, and the support member between the outside lid portion and the fixing member.

Therefore, it is possible to protect the electronic component and the circuit device.

In the electronic device, it is preferable that the housing space be airtightly sealed.

Therefore, it is possible to dispose the electronic component and the circuit device in a predetermined atmosphere.

In the electronic device, it is preferable that the support member and the fixing member include the same material as each other.

Therefore, it is possible to reduce occurrence of a stress due to a difference in linear expansion coefficient between the support member and the fixing member.

According to another aspect of the invention, there is provided an electronic apparatus including the electronic device of the invention.

Therefore, it is possible to obtain the electronic apparatus having high reliability.

According to still another aspect of the invention, there is provided a moving object including the electronic device of the invention.

Therefore, it is possible to obtain the moving object having high reliability.

### BRIEF DESCRIPTION OF THE DRAWINGS

The invention will be described with reference to the accompanying drawings, wherein like numbers reference like elements.
Fig. 1 is a sectional view of an electronic device according to a first embodiment of the invention.
Fig. 2 is a plan view of the electronic device illustrated in Fig. 1.
Fig. 3 is a plan view of a physical quantity sensor included in the electronic device illustrated in Fig. 1.
Fig. 4 is a sectional view that is taken along line IV-IV in Fig. 3.
Fig. 5 is a sectional view of an IC included in the electronic device illustrated in Fig. 1.
Fig. 6 is a sectional view of an electronic device according to a second embodiment of the invention.
Fig. 7 is a sectional view of an electronic device according to a third embodiment of the invention.
Figs. 8A and 8B are sectional views illustrating a state where a support member included in the electronic device illustrated in Fig. 7 is deformed.
Fig. 9 is a sectional view of an electronic device according to a fourth embodiment of the invention.
Fig. 10 is a perspective view illustrating a configuration of a mobile type (or laptop type) personal computer to which an electronic apparatus of the invention is applied.
Fig. 11 is a perspective view illustrating a configuration of a mobile phone (also including a smartphone, a PHS, and the like) to which the electronic apparatus of the invention is applied.
Fig. 12 is a perspective view illustrating a configuration of a digital still camera to which the electronic apparatus of the invention is applied and also briefly illustrating connection with an external device.
Fig. 13 is a perspective view illustrating an automobile to which a moving object of the invention is applied.

### DESCRIPTION OF EXEMPLARY EMBODIMENTS

Hereinafter, an electronic device, an electronic apparatus, and a moving object of the invention will be described with reference to the drawings in detail.

### First Embodiment

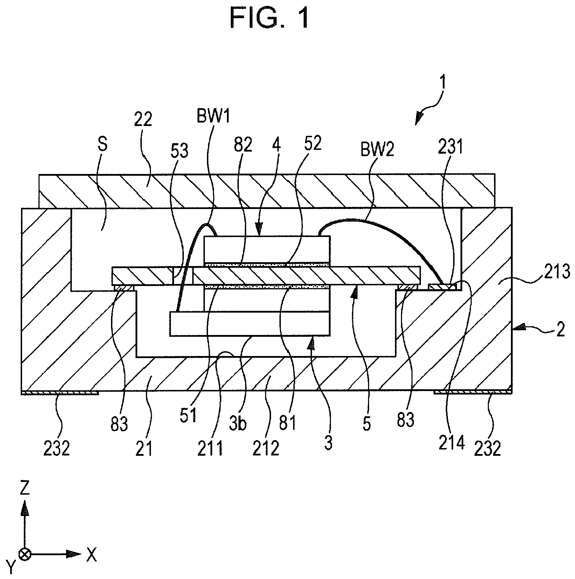

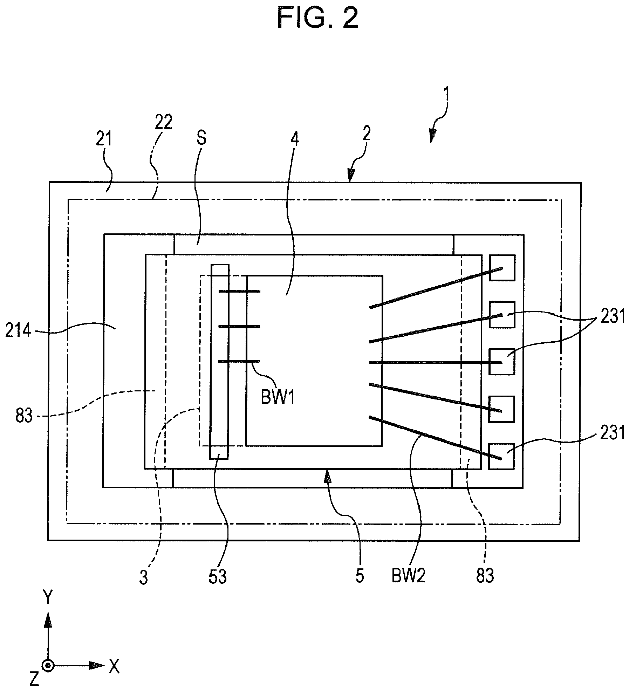

Fig. 1 is a sectional view of an electronic device according to a first embodiment of the invention. Fig. 2 is a plan view of the electronic device illustrated in Fig. 1.

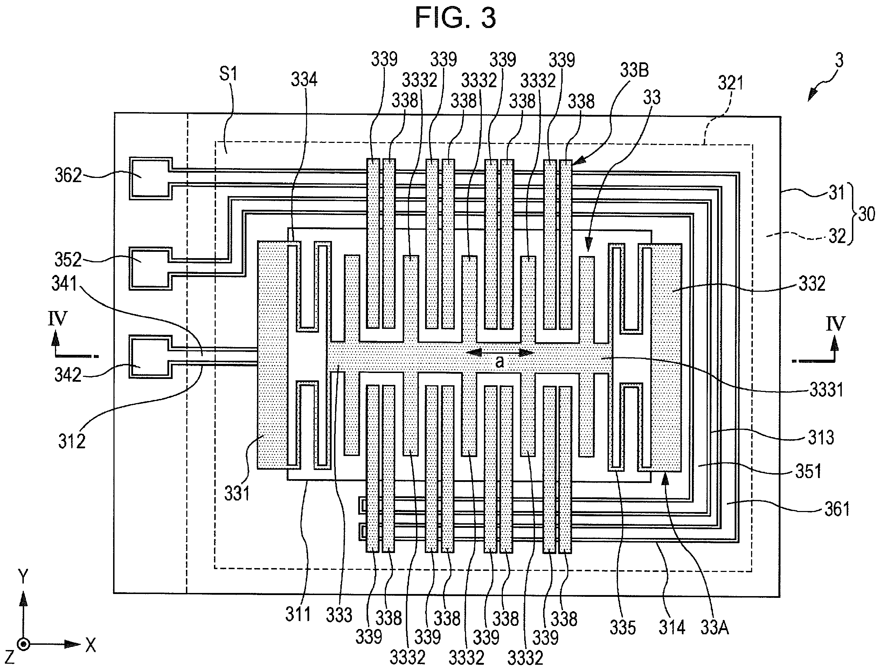

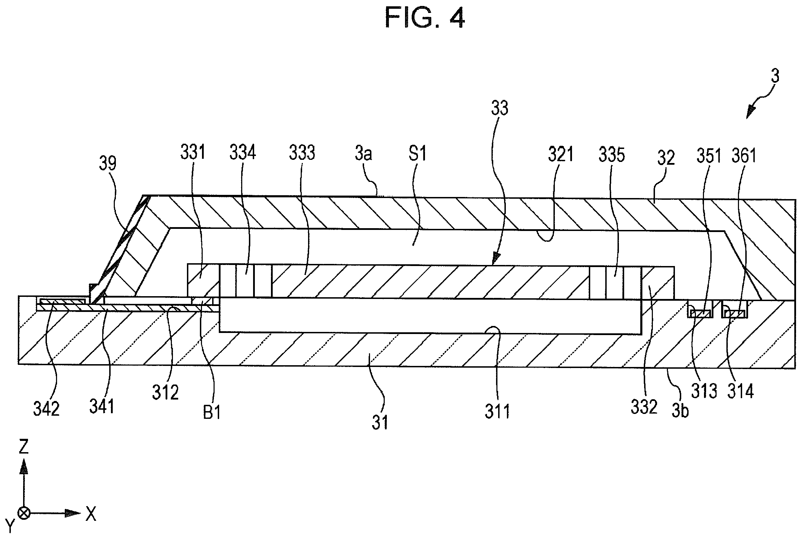

Fig. 3 is a plan view of a physical quantity sensor included in the electronic device illustrated in Fig. 1. Fig. 4 is a sectional view that is taken along line IV-IV in Fig. 3.

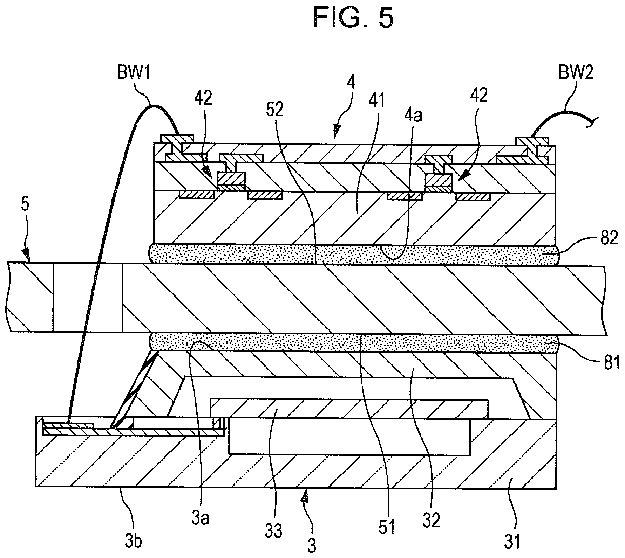

Fig. 5 is a sectional view of an IC included in the electronic device illustrated in Fig. 1. Moreover, in the following description, for the sake of convenience of description, an upper side is referred to as "upper" and a lower side is referred to as "lower" in Fig. 1. Moreover, in each figure, as three axes orthogonal to each other, an X axis, a Y axis, and a Z axis are illustrated. Moreover, in the following description, a direction parallel to the X axis is referred to as "X-axis direction", a direction parallel to the Y axis is referred to as "Y-axis direction", and a direction parallel to the Z axis is referred to as "Z-axis direction".

The electronic device 1 illustrated in Fig. 1 has a package 2, a physical quantity sensor (electronic component) 3 that is housed in the package 2, an IC (circuit device) 4, and a support member 5. Hereinafter, each of the configurations will be described in order.

### Package

As illustrated in Fig. 1, the package 2 has a cavity-shaped package base (fixing member) 21 having a recessed portion 211 opening to an upper surface and a plate-like package lid body (outside lid portion) 22 that is joined to the package base 21 by blocking an opening of the recessed portion 211. Such a package 2 has an airtight housing space S that is formed by blocking the recessed portion 211 by the package lid body 22 and the physical quantity sensor 3, the IC 4, and the support member 5 are housed in the housing space S. According to such a package 2, it is possible to protect the physical quantity sensor 3 and the IC 4 housed on an inside thereof from the outside.

Moreover, an atmosphere within the housing space S is appropriately set by a configuration of the physical quantity sensor 3 and, for example, can be a reduced pressure (preferably vacuum) state, or an atmospheric pressure state filled with an inert gas such as nitrogen or argon at atmospheric pressure. In the embodiment, the atmosphere within the housing space S is the same as that of an internal space S1 of the physical quantity sensor 3.

In addition, the package base 21 has a bottom portion 212 and a frame-like side wall portion 213 standing upright from an outer periphery portion of the bottom portion 212, and a stepped portion 214 is formed in an inner periphery portion of the side wall portion 213. In addition, an appropriate number of internal terminals 231 are formed in the stepped portion 214 and an appropriate number of external terminals 232 are also formed on a bottom surface of the package base 21. Therefore, each of the internal terminals 231 and the external terminal 232 corresponding thereto are electrically connected by internal wiring (not illustrated) provided within the package base 21.

A configuration material of such a package base 21 is not particularly limited, but various kinds of ceramics such as aluminum oxide (alumina) can be used. In addition, a configuration material of such a package lid body 22 is not particularly limited, but it is preferable to be a member having a linear expansion coefficient close to that of the package base 21. For example, in a case where the configuration material of the package base 21 is the ceramics as described above, it is preferable to use an alloy such as kovar.

### Support Member

The support member 5 has a plate shape and as illustrated in Fig. 2, is fixed to the stepped portion 214 (the side wall portion 213) of the package base 21 via joining members 83 at both end portions. In addition, the support member 5 has a first fixing surface 51 for fixing the physical quantity sensor 3 and a second fixing surface 52 for fixing the IC 4 at the center portion thereof. As described above, the configuration of the electronic device 1 is simplified by fixing the support member 5 to the side wall portion 213. In addition, a posture of the support member 5 is stabilized by fixing the support member 5 to the package base 21 at the both end portions (that is, both sides of the first and second fixing surfaces 51 and 52). Particularly, it is easy to dispose the support member 5 (first and second fixing surfaces 51 and 52) in parallel to the bottom surface of the package base 21. Therefore, it is easy to control a posture of the physical quantity sensor 3 fixed to the support member 5 and it is possible to reduce degradation of detection accuracy of the physical quantity sensor 3 and the like (physical quantity sensor 3 of the embodiment has a property that the detection accuracy is lowered depending on the posture).

The first fixing surface 51 is provided on a lower surface (surface on a bottom portion 212 side of the package base 21) at a center portion of the support member 5 and the second fixing surface 52 is provided on an upper surface (surface on a package lid body 22 side) at the center portion of the support member 5. The first and second fixing surfaces 51 and 52 are disposed to face each other. In addition, the physical quantity sensor 3 is fixed to the first fixing surface 51 via adhesive 81 and the IC 4 is fixed to the second fixing surface 52 via adhesive 82. The adhesives 81 and 82 are not particularly limited, but various resin adhesive materials such as acrylic based, epoxy based, and urethane based can be used. In addition, as the adhesives 81 and 82, an adhesive material in which an inorganic filler is dispersed in the resin in order to adjust the linear expansion coefficient may be used.

In addition, a through hole 53 is provided in the vicinity of the first and second fixing surfaces 51 and 52 of the support member 5. A bonding wire BW1 for electrically connecting the physical quantity sensor 3 and the IC 4 can pass through the through hole 53. In addition, it is possible to absorb a stress applied to the support member 5 by providing the through hole 53.

A configuration material of such a support member 5 is not particularly limited, but it is preferable to be a member having a linear expansion coefficient close to that of the package base 21. Therefore, a thermal stress due to a difference in the linear expansion coefficient between the support member 5 and the package base 21 is unlikely to occur and accordingly the stress is also unlikely to be transmitted to the physical quantity sensor 3. In addition, it is preferable that the support member 5 be relatively hard. Therefore, vibration of the support member 5 is reduced and degradation of detection accuracy of an acceleration of the physical quantity sensor 3 is suppressed. Particularly, in the embodiment, the support member 5 is configured of the same material (for example, various ceramics such as aluminum oxide (alumina)) as that of the package base 21 and thereby a difference in the linear expansion coefficient is substantially zero. Therefore, it is possible to exhibit the effects described above more remarkably.

### Physical Quantity Sensor

The physical quantity sensor 3 is an acceleration sensor that can detect the acceleration in the X-axis direction (in-plane direction). As illustrated in Figs. 3 and 4, such a physical quantity sensor 3 has a package 30 having a base 31 and a lid body 32, and an element piece (functional element) 33 that is disposed in the internal space S1 of the package 30.

The base 31 has a recessed portion 311 opening to an upper surface. The recessed portion 311 functions as a relief portion for preventing contact between the element piece 33 and the base 31. In addition, the base 31 has recessed portions 312, 313, and 314 that are opened to the upper surface thereof and disposed on an outer periphery of the recessed portion 311. Therefore, wiring 341 and a terminal 342 are formed in the recessed portion 312, wiring 351 and a terminal 352 are formed in the recessed portion 313, and wiring 361 and a terminal 362 are formed in the recessed portion 314. In addition, the terminals 342, 352, and 362 are respectively disposed so as to be exposed to the outside of the physical quantity sensor 3 and can be electrically connected to the IC 4 via the terminals 342, 352, and 362.

Such a base 31 is formed of a glass material (for example, borosilicate glass such as Pyrex glass (registered trademark)) containing alkali metal ions (movable ions). However, the configuration material of the base 31 is not limited to the glass material and, for example, a high resistance silicon substrate may be used.

The lid body 32 has a recessed portion 321 opening to a lower surface and the internal space S1 is formed by the recessed portion 321. Such a lid body 32 is formed of silicon. Therefore, the lid body 32 and the base 31 can be joined by anodic joining. However, the configuration material of the lid body 32 is not limited to silicon and a method of joining to the base 31 is not limited to the anodic joining.

In addition, in a state where the lid body 32 is merely joined to the base 31, the inside and outside of the internal space S1 communicate with each other via the recessed portions 312, 313, and 314 formed in the base 31. Therefore, in the embodiment, as illustrated in Fig. 4, the recessed portions 312, 313, and 314 are blocked by a SiO₂ film 39 formed by a CVD method using tetraethoxysilane (TEOS) or the like.

The element piece 33 is joined to an upper surface of the base 31 so as to overlap the recessed portion 311. In addition, the element piece 33 has a first structure body 33A having a portion capable of displacing with respect to the base 31 and a second structure body 33B of which a position is fixed to the base 31. Such an element piece 33 is formed of a silicon substrate doped with impurities such as phosphorus and boron. In addition, the element piece 33 is joined to the base 31 by anodic joining.

The first structure body 33A has the support portions 331 and 332, a movable portion 333, and connecting portions 334 and 335. The support portions 331 and 332 are disposed to face each other in the X-axis direction via the recessed portion 311 and are respectively joined to the base 31. In addition, the support portion 331 is electrically connected to the wiring 341 via a conductive bump B1.

The movable portion 333 is positioned between the support portions 331 and 332. The movable portion 333 is connected to the support portion 331 via the connecting portion 334 in a -X axis side and is connected to the support portion 332 via the connecting portion 335 in a +X axis side. Therefore, the movable portion 333 can be displaced in the X-axis direction with respect to the support portions 331 and 332 as indicated by arrow a while elastically deforming the connecting portions 334 and 335. In addition, the movable portion 333 has a base portion 3331 extending in the X-axis direction and a plurality of movable electrode fingers 3332 that protrude from the base portion 3331 on both sides in the Y-axis direction and are disposed like comb teeth.

The second structure body 33B has a plurality of first fixed electrode fingers 338 and a plurality of second fixed electrode fingers 339. The plurality of first fixed electrode fingers 338 are disposed on one side in the X-axis direction of each movable electrode finger 3332 and are disposed like comb teeth meshing with the corresponding movable electrode fingers 3332 spaced apart therebetween. On the other hand, the plurality of second fixed electrode fingers 339 are disposed on the other side in the X-axis direction of each movable electrode finger 3332 and are disposed like comb teeth meshing with the corresponding movable electrode fingers 3332 spaced apart therebetween. Therefore, each first fixed electrode finger 338 is electrically connected to the wiring 351 via a conductive bump and each second fixed electrode finger 339 is electrically connected to the wiring 361 via a conductive bump.

Such a physical quantity sensor 3 detects the acceleration as follows. That is, if the acceleration in the X-axis direction is applied to the physical quantity sensor 3, the movable portion 333 is displaced in the X-axis direction while elastically deforming the connecting portions 334 and 335 based on the size of the acceleration. Along with such displacement, a gap between the movable electrode finger 3332 and the first fixed electrode finger 338, and a gap between the movable electrode finger 3332 and the second fixed electrode finger 339 are respectively changed, and along with the displacement, a size of an electrostatic capacity between the movable electrode finger 3332 and the first fixed electrode finger 338, and a size of an electrostatic capacity between the movable electrode finger 3332 and the second fixed electrode finger 339 are respectively changed. Therefore, it is possible to detect the acceleration based on the change (differential signal) in the electrostatic capacities.

Here, it is preferable that the internal space S1 be filled with inert gas such as nitrogen, helium, and argon, and be substantially at atmospheric pressure at an operating temperature (approximately -40°C to 80°C). A viscose resistance is increased, the damping effect is achieved, and vibration of the movable portion 333 can be promptly converged (stopped) because the internal space S1 is set as atmospheric pressure. Therefore, the detection accuracy of the acceleration is improved.

The physical quantity sensor 3 is described above. As illustrated in Fig. 5, the physical quantity sensor 3 is fixed to the first fixing surface 51 of the support member 5 via the adhesive 81 in an upper surface 3a (lid body 32). As described above, the lid body 32 is fixed to the first fixing surface 51 and thereby a stress (thermal stress due to a difference in the linear expansion coefficient between the support member 5 and a package base 21, thermal stress due to a difference between the linear expansion coefficient between the support member 5 and the lid body 32, stress due to deflection of the support member 5, and the like) is unlikely to be transmitted to the element piece 33. More specifically, the stress that is transmitted from the lid body 32 to the physical quantity sensor 3 is propagated to the element piece 33 via a path of the lid body 32, the base 31, and the element piece 33 in order. Therefore, it is possible to lengthen a propagation distance until the stress is transmitted to the element piece 33 and accordingly, the stress is unlikely to be transmitted to the element piece 33. Therefore, it is possible to reduce deterioration of the detection accuracy of the physical quantity sensor 3.

Moreover, the linear expansion coefficient of the adhesive 81 is not particularly limited, but is preferably positioned between the linear expansion coefficient of the support member 5 and the linear expansion coefficient of the physical quantity sensor 3 (lid body 32).

In addition, a bottom surface 3b (base 31) of the physical quantity sensor 3 is disposed to face a bottom portion 212 of the package 2. In addition, a space is formed between the bottom surface 3b and the bottom portion 212, and is disposed in a state where the physical quantity sensor 3 is suspended from the bottom portion 212. With such a configuration, contact between the physical quantity sensor 3 and other members can be minimized as much as possible and the stress is unlikely to be transmitted to the physical quantity sensor 3.

In addition, as described above, in the embodiment, since the housing space S of the package 2 is substantially the same environment as that of the internal space S1 of the physical quantity sensor 3, for example, even if sealing of the internal space S1 is broken and the internal space S1 communicates with the housing space S, the environment of the internal space S1 is not substantially changed. Therefore, it is possible to reduce deterioration of the detection accuracy of the physical quantity sensor 3. IC

The IC 4 includes, for example, a drive circuit (oscillation circuit) that drives the physical quantity sensor 3, a detection circuit that detects the acceleration from the differential signal, an output circuit that converts a signal from the detection circuit to a predetermined signal and outputs the predetermined signal, and the like. Such an IC 4 has a known configuration and, for example, as illustrated in Fig. 5, is configured by disposing a circuit element 42 such as a transistor on a semiconductor substrate 41 that is configured of silicon. Such an IC 4 is fixed to the second fixing surface 52 of the support member 5 via the adhesive 82 in the lower surface 4a (semiconductor substrate 41). In addition, the IC 4 is electrically connected to the physical quantity sensor 3 via a bonding wire BW1 and is electrically connected to the internal terminal 231 of the package 2 via a bonding wire BW2.

Moreover, the linear expansion coefficient of the adhesive 82 is not particularly limited, but is preferably positioned between the linear expansion coefficient of the support member 5 and the linear expansion coefficient of the IC 4 (semiconductor substrate 41).

The electronic device 1 is described above. According to such an electronic device 1, the physical quantity sensor 3 is fixed to the package base 21 via the support member 5 and the physical quantity sensor 3 is disposed in a state of being suspended from the package base 21. Therefore, the stress is unlikely to be transmitted to the physical quantity sensor 3 and it is possible to effectively suppress deterioration of the detection accuracy of acceleration of the physical quantity sensor 3.

Particularly, in the embodiment, the physical quantity sensor 3 is fixed to a lower side of the support member 5 and the IC 4 is fixed to the upper side thereof. That is, the physical quantity sensor 3 and the IC 4 are disposed to face each other via the support member 5. With such disposition, it is easy to fix (attach) the physical quantity sensor 3 and the IC 4 to the support member 5. In addition, it is also possible to suppress planar spread of the electronic device 1. However, the disposition of the physical quantity sensor 3 and the IC 4 is not particularly limited and, for example, the disposition of the physical quantity sensor 3 and the IC 4 may be reversed, or both may be disposed on the upper surface or the lower surface of the support member 5.

Furthermore, as described above, the lid body 32 of the physical quantity sensor 3 is formed of silicon and the semiconductor substrate 41 of the IC 4 is also formed of silicon. Therefore, the support member 5 is configured to be interposed between the lid body 32 and the semiconductor substrate 41 that are formed the same material (silicon). With such a configuration, it is possible to reduce warp (deflection) of the support member 5 during thermal expansion and the thermal stress is unlikely to occur. Therefore, it is possible to effectively suppress deterioration of the detection accuracy of the acceleration of the physical quantity sensor 3.

### Second Embodiment

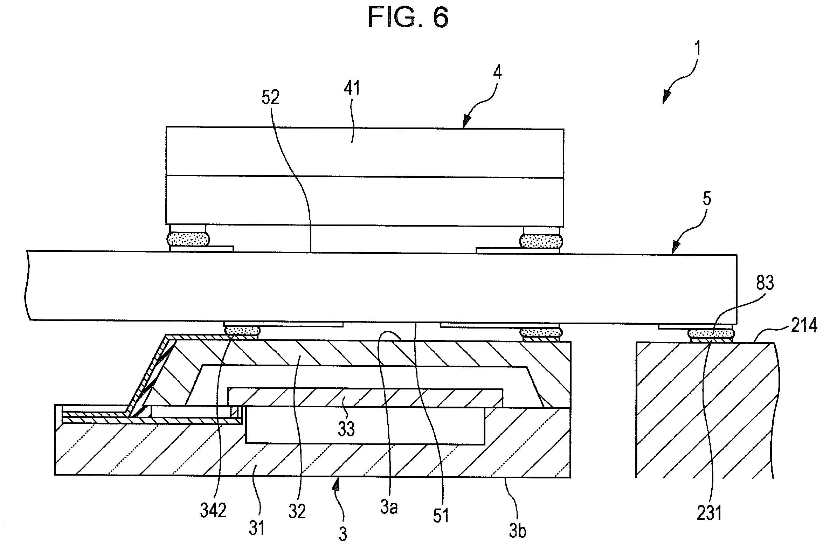

Fig. 6 is a sectional view of an electronic device according to a second embodiment of the invention.

A physical quantity sensor according to the embodiment is the same as that of the electronic device according to the first embodiment, except mainly that a configuration of a support member is different.

Moreover, in the following description, the electronic device of the second embodiment will be described focusing on differences from the embodiment described above and description of similar matters will be omitted. In addition, in Fig. 6, the same reference numerals are given to the same configurations as those of the embodiment described above.

In an electronic device 1 of the embodiment, as illustrated in Fig. 6, a support member 5 includes wiring that electrically connects a physical quantity sensor 3 and an IC 4, and wiring that electrically connects the IC 4 and an internal terminal 231, and also functions as a wiring substrate. In addition, in the support member 5, a through hole 53 provided in the first embodiment described above is omitted. In the physical quantity sensor 3, a terminal 342 is drawn out to an upper surface of a lid body 32, is fixed to the support member 5 by conductive adhesive, solder, or the like, and is electrically connected to the wiring of the support member 5. On the other hand, the IC 4 is fixed to the support member 5 by conductive adhesive, solder, or the like, in a state where the IC 4 is turned upside down, and is electrically connected to the wiring of the support member 5. In addition, the support member 5 is electrically connected to the internal terminal 231 via a joining member 83.

Even with such a second embodiment, it is possible to effectively achieve the same effects as those of the first embodiment described above.

### Third Embodiment

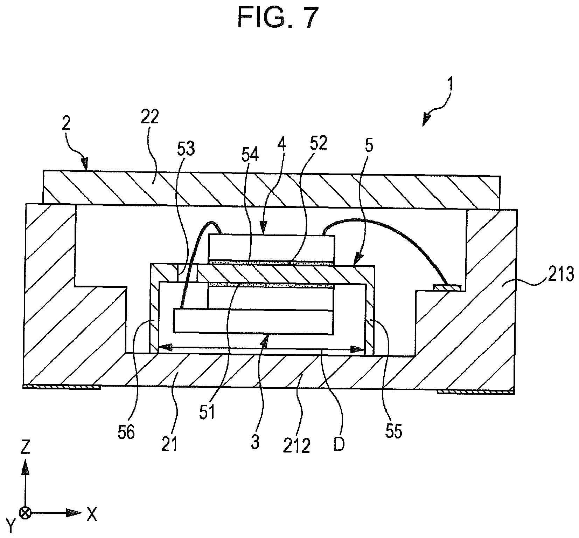

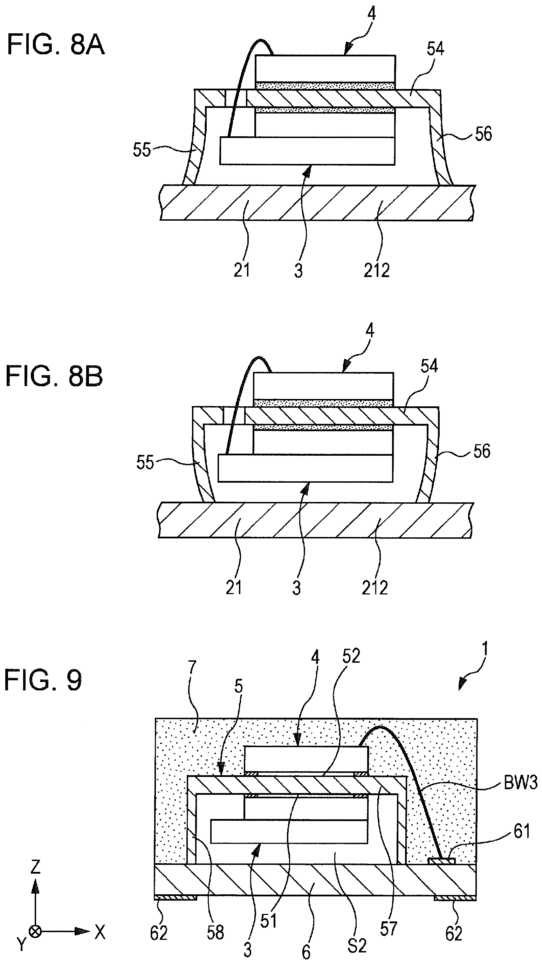

Fig. 7 is a sectional view of an electronic device according to a third embodiment of the invention. Figs. 8A and 8B are sectional views illustrating a state where a support member included in the electronic device illustrated in Fig. 7 is deformed.

A physical quantity sensor according to the embodiment is the same as that of the electronic device according to the first embodiment, except mainly that a configuration of a support member is different.

Moreover, in the following description, the electronic device of the third embodiment will be described focusing on differences from the embodiments described above and description of similar matters will be omitted. In addition, in Figs. 7 to 8B, the same reference numerals are given to the same configurations as those of the embodiment described above.

In an electronic device 1 of the embodiment, as illustrated in Fig. 7, a support member 5 has a base portion 54 that is disposed to face a bottom portion 212 of a package base 21 spaced apart from each other and is disposed substantially parallel thereto, and connecting portions 55 and 56 that are disposed between the base portion 54 and the bottom portion 212, and connect the base portion 54 and the bottom portion 212. In addition, the connecting portions 55 and 56 stand upright substantially vertically with respect to the bottom portion 212, and are connected to both end portions (that is, both sides of first and second fixing surfaces 51 and 52) of the base portion 54. Therefore, the physical quantity sensor 3 is fixed to the first fixing surface 51 that is provided on a lower surface of the base portion 54 and the IC 4 is fixed to the second fixing surface 52 that is provided on an upper surface of the base portion 54.

With such a configuration, a configuration of the electronic device 1 is simplified. Furthermore, a separation distance D between portions of the support member 5 that are fixed to a package base 21 is reduced compared to the first embodiment described above. Therefore, for example, in a case where the linear expansion coefficients of the package base 21 and the support member 5 are different, it is possible to reduce the stress which occurs due to a difference in the linear expansion coefficient.

Particularly, in the embodiment, a thickness of the connecting portions 55 and 56 is thinner than a thickness of the base portion 54 and the connecting portions 55 and 56 are easily deflected in a thickness direction thereof. Therefore, as illustrated in Figs. 8A and 8B, the connecting portions 55 and 56 are deformed and thereby the stress between the base portion 54 and the package base 21 is relieved and the stress is unlikely to be transmitted to the physical quantity sensor 3.

Even with such a third embodiment, it is possible to effectively achieve the same effects as those of the first embodiment described above.

### Fourth Embodiment

Fig. 9 is a sectional view of an electronic device according to a fourth embodiment of the invention.

A physical quantity sensor according to the embodiment is the same as that of the electronic device according to the first embodiment, except mainly that configurations of a package and a support member are different.

Moreover, in the following description, the electronic device of the fourth embodiment will be described focusing on differences from the embodiments described above and description of similar matters will be omitted. In addition, in Fig. 9, the same reference numerals are given to the same configurations as those of the embodiment described above.

As illustrated in Fig. 9, an electronic device 1 of the embodiment has a substrate (fixing member) 6, a support member 5 that is fixed to the substrate 6, a physical quantity sensor 3 and an IC 4 that are fixed to the support member 5, and a molding material 7 for molding the support member 5, the physical quantity sensor 3, and the IC 4. As the molding material 7, for example, it is possible to use thermosetting epoxy resin and it is possible to mold the molding material 7 using a transfer mold method.

In addition, the support member 5 has a base portion 57 that is disposed to face the substrate 6 spaced apart from each other and is disposed substantially parallel to each other, and a frame-like side wall portion 58 that is disposed between the base portion 57 and the substrate 6, and connects the base portion 57 and the substrate 6. Therefore, the physical quantity sensor 3 is fixed to a first fixing surface 51 provided on a lower surface of the base portion 57 and the IC 4 is fixed to a second fixing surface 52 provided on an upper surface of the base portion 57. Moreover, the base portion 57 is, for example, a wiring substrate similar to that of the second embodiment described above and electrically connects the physical quantity sensor 3 and the IC 4 via the base portion 57.

In addition, a space S2, which is surrounded by the support member 5 and the substrate 6, and in which the physical quantity sensor 3 is housed, is sealed to such an extent that the molding material 7 cannot enter and is preferably airtightly sealed.

In addition, a plurality of internal terminals 61 are disposed on the upper surface of the substrate 6 and a plurality of external terminals 62 that are electrically connected to the internal terminals 61 via internal wiring (not illustrated) are disposed on a lower surface thereof. In addition, each internal terminal 61 is electrically connected to the IC 4 via a bonding wire BW3. Such a substrate 6 is not particularly limited, and, for example, a silicon substrate, a ceramic substrate, a resin substrate, a glass substrate, a glass epoxy substrate, or the like can be used.

Even with such a fourth embodiment, it is possible to effectively achieve the same effects as those of the first embodiment described above.

### Electronic Apparatus

Next, an electronic apparatus of the invention will be described.

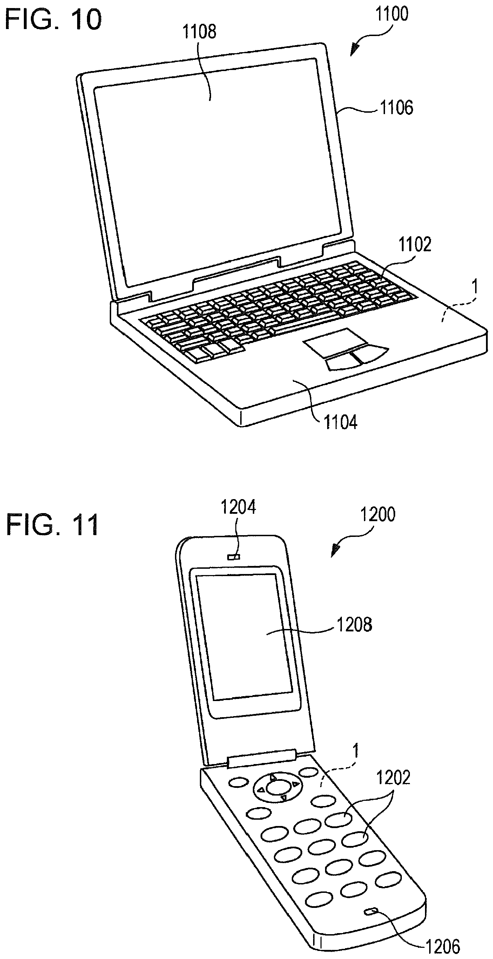

Fig. 10 is a perspective view illustrating a configuration of a mobile type (or laptop type) personal computer to which the electronic apparatus of the invention is applied.

In this drawing, a personal computer 1100 is configured of a body portion 1104 including a keyboard 1102 and a display unit 1106 including a display portion 1108. The display unit 1106 is rotatably supported to the body portion 1104 via a hinge structure portion. An electronic device 1 is built in such a personal computer 1100.

Fig. 11 is a perspective view illustrating a configuration of a mobile phone (also including a smartphone, a PHS, and the like) to which the electronic apparatus of the invention is applied.

In this drawing, a mobile phone 1200 includes an antenna (not illustrated), a plurality of operation buttons 1202, an earpiece 1204, and a mouthpiece 1206, and a display portion 1208 is disposed between the operation buttons 1202 and the earpiece 1204. The electronic device 1 is built in such a mobile phone 1200.

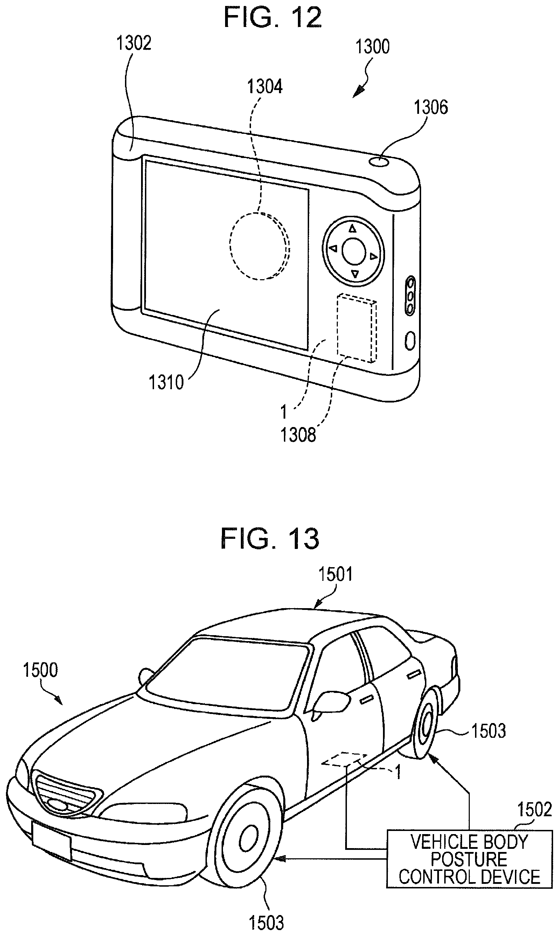

Fig. 12 is a perspective view illustrating a configuration of a digital still camera to which the electronic apparatus of the invention is applied. In addition, in the drawing, connection to an external apparatus is also briefly illustrated.

A display portion 1310 is provided on a rear surface of a case (body) 1302 in a digital still camera 1300 and is configured to perform a display based on an imaging signal by CCD. The display portion 1310 functions as a finder that displays an object as an electronic image. In addition, a light receiving unit 1304 including an optical lens (optical system), the CCD, and the like is provided on a front side (rear surface side in the drawing) of the case 1302. Therefore, if a photographer confirms an object image displayed on the display portion 1310 and presses a shutter button 1306, at this time, an imaging signal of the CCD is transferred and stored in a memory 1308. The electronic device 1 that is used for correcting shake, for example, as an acceleration sensor is built in the digital still camera 1300.

Since such an electronic apparatus includes the electronic device 1, the electronic apparatus has excellent reliability.

In addition, the electronic apparatus of the invention can be applied to, for example, a smartphone, a tablet terminal, a clock (including smart watch), an ink jet type ejecting apparatus (for example, an ink jet printer), a laptop personal computer, a television, a wearable terminal such as a head mounted display (HMD), a video camera, a video tape recorder, a car navigation apparatus, a pager, an electronic diary (also including communication function), an electronic dictionary, an electronic calculator, an electronic game apparatus, a word processor, a workstation, a television telephone, a security television monitor, electronic binoculars, a POS terminal, a medical apparatus (for example, an electronic thermometer, a blood pressure monitor, a blood glucose meter, an electrocardiogram measuring apparatus, an ultrasonic diagnostic apparatus, and an electronic endoscope), a fish finder, various measuring apparatuses, measurement equipment (for example, measurement equipment for a vehicle, an aircraft, and a ship), a flight simulator or the like, in addition to the personal computer in Fig. 10, the mobile phone in Fig. 11, and the digital still camera in Fig. 12.

### Moving object

Next, the moving object of the invention will be described.

Fig. 13 is a perspective view illustrating an automobile to which the moving object of the invention is applied.

As illustrated in Fig. 13, an electronic device 1 is built in an automobile 1500 and, for example, it is possible to detect a posture of a vehicle body 1501 by the electronic device 1. A detection signal of the electronic device 1 is supplied to a vehicle body posture control device 1502, the vehicle body posture control device 1502 detects the posture of the vehicle body 1501 based on the signal, and it is possible to control hardness of suspension according to a detection result or control brake of individual wheel 1503. In addition, the electronic device 1 can be widely applied to an electronic control unit (ECU) such as in keyless entry, an immobilizer, a car navigation system, car air conditioning, an anti-lock braking system (ABS), an airbag, a tire pressure monitoring system (TPMS), an engine controller, a battery monitor of a hybrid vehicle or an electric vehicle, a vehicle body attitude control system or the like.

Although the electronic device, the electronic apparatus, and the moving object of the invention are described based on the illustrated embodiments, the invention is not limited to the embodiments and the configuration of each portion can be replaced by an arbitrary configuration having the same function. In addition, any other constituent may be added to the invention.

In addition, in the embodiments described above, as the electronic component, the configuration which uses the physical quantity sensor capable of detecting the acceleration is described, but the invention is not limited to the embodiments, and, for example, the physical quantity sensor may be a physical quantity sensor capable of detecting an angular velocity or may be a composite sensor capable of detecting both the acceleration and the angular velocity. In addition, a detection axis of the acceleration is not limited to one axis and may detect accelerations in two axial directions among the X axis, the Y axis, and the Z axis, or may detect accelerations in three axial directions. The same applies to the detection axis of the angular velocity. In addition, the electronic component is not limited to the physical quantity sensor and, for example, may be an oscillator.

## Claims

1. An electronic device comprising:
a package including a base and a lid body joined to the base, and an electronic component having a functional element housed in the package;
a circuit device that is electrically connected to the electronic component;
a support member that supports the electronic component and the circuit device; and
a fixing member that fixes the support member,
wherein the electronic component is disposed to be spaced apart from the fixing member, and
wherein the electronic component is suspended from the fixing member in a direction in which the electronic component is spaced apart from the fixing member.

2. The electronic device according to Claim 1,
wherein the electronic component and the circuit device are disposed to face each other via the support member.

3. The electronic device according to Claim 1 or 2,
wherein the functional element is fixed to the base, and
wherein the electronic component is fixed to the support member in the lid body.

4. The electronic device according to any one of the preceding claims,
wherein the circuit device has a circuit device substrate and a circuit element that is disposed in the circuit device substrate, and
wherein the lid body and the circuit device include the same material as each other.

5. The electronic device according to any one of the preceding claims,
wherein the fixing member has a bottom portion and a side wall portion standing upright from the bottom portion, and
wherein the support member is fixed to the side wall portion.

6. The electronic device according to any one of the preceding claims,
wherein the support member has a base portion that is disposed to face the fixing member with a gap therebetween and a connecting portion that is disposed between the base portion and the fixing member, and connects the base portion and the fixing member.

7. The electronic device according to any one of the preceding claims, further comprising:
an outside lid portion that is joined to the fixing member so as to form a housing space for housing the electronic component, the circuit device, and the support member between the outside lid portion and the fixing member.

8. The electronic device according to Claim 7,
wherein the housing space is airtightly sealed.

9. The electronic device according to any one of the preceding claims,
wherein the support member and the fixing member include the same material as each other.

10. An electronic apparatus comprising:
the electronic device according to any one of the preceding claims.

11. A moving object comprising:
the electronic device according to any one of claims 1 to 9.
